Europäisches Patentamt

European Patent Office

Office européen des brevets

(19)

(11) Numéro de publication : **0 025 391**
**B1**

(12) # FASCICULE DE BREVET EUROPÉEN

(45) Date de publication du fascicule du brevet :
**13.06.84**

(51) Int. Cl.³ : **H 03 B   5/30**, B 61 L   1/20

(21) Numéro de dépôt : **80401253.2**

(22) Date de dépôt : **02.09.80**

(54) Oscillateur basse fréquence à diapason à sécurité intrinsèque et émetteur incluant un tel oscillateur.

(30) Priorité : **07.09.79 FR 7922384**

(43) Date de publication de la demande :
**18.03.81 Bulletin 81/11**

(45) Mention de la délivrance du brevet :
**13.06.84 Bulletin 84/24**

(84) Etats contractants désignés :
**DE GB IT NL**

(56) Documents cités :
**DE-A- 1 513 072**
**GB-A- 1 005 222**
**US-A- 3 609 578**

(73) Titulaire : **JEUMONT-SCHNEIDER Société anonyme dite:**
**31-32, Quai de Dion Bouton**
**F-92811 Puteaux Cedex (FR)**

(72) Inventeur : **Salmon, Jean**
**28, rue Turgot**
**F-93600 Aulnay Sous Bois (FR)**
Inventeur : **Marchand, Patrick**
**8, rue Victor Hugo**
**F-95130 Le Plessis Bouchard (FR)**

(74) Mandataire : **Paume, André et al**
**31-32, Quai de Dion Bouton**
**F-92811 Puteaux Cedex (FR)**

Jouve, 18, rue St-Denis, 75001 Paris, France

## Description

La présente invention concerne un oscillateur basse fréquence à diapason dit à sécurité intrinsèque puisque le signal de sortie doit présenter un niveau constant quelles que soient les conditions de fonctionnement, et que de tout incident doit résulter un affaiblissement ou une extinction du signal de sortie.

Les oscillateurs BF à diapason sont généralement réalisés à l'aide de circuits différentiels permettant d'obtenir un couplage magnétique entre l'entrée et la sortie de l'oscillateur.

Un tel oscillateur à diapason est par exemple décrit dans le brevet américain 3 609 578.

Toutefois, dans certaines de ses applications, par exemple dans les applications ferroviaires de transmissions, un tel oscillateur doit fonctionner selon des critères extrêmement étroits. Par exemple, toute augmentation intempestive de résistance due à une mauvaise soudure des composants ou à la destruction d'une jonction d'un transistor, doit entraîner une extinction du signal de sortie ou tout au moins un affaiblissement du signal par rapport à son niveau nominal, ce que l'on appelle « sécurité intrinsèque ».

L'oscillateur décrit dans le brevet américain précité n'est pas un oscillateur à sécurité intrinsèque car l'amplitude du signal de sortie peut augmenter en cas de défaillance de l'un de ses composants.

La présente invention a pour but un tel oscillateur à sécurité intrinsèque.

Selon l'invention, l'oscillateur basse fréquence à diapason à sécurité intrinsèque alimenté en tension continue, comportant essentiellement en chaîne un amplificateur différentiel fonctionnant à saturation en mode opérationnel, à la première entrée duquel est connecté l'enroulement de sortie dudit diapason, un transistor monté en amplificateur à émetteur commun à la sortie dudit amplificateur différentiel, la sortie dudit transistor étant connectée à l'enroulement de commande dudit diapason, de manière à former une réaction par couplage magnétique avec ladite première entrée dudit amplificateur différentiel, et un circuit-bouchon dont l'inductance, reliée au collecteur dudit transistor par l'intermédiaire d'une résistance, est constituée par l'enroulement primaire d'un transformateur sur l'enroulement secondaire duquel est recueilli le signal de sortie dudit oscillateur, est caractérisé en ce qu'un premier et un second circuits régulateurs de tension sont connectés en parallèle entre les bornes de la source de tension continue d'alimentation, ledit premier circuit ayant ses bornes de sortie reliées à la première entrée de l'amplificateur différentiel par l'intermédiaire d'un premier pont diviseur de tension, ledit second circuit ayant ses bornes de sortie reliées à la seconde entrée de l'amplificateur différentiel par l'intermédiaire d'un second pont diviseur de tension et aux bornes d'entrée d'alimentation dudit amplificateur différentiel de telle manière que de la modification intempestive de l'une quelconque des caractéristiques desdits circuits résulte un affaiblissement notable du niveau du signal de sortie dudit oscillateur.

L'invention sera mieux comprise et d'autres buts, caractéristiques et avantages de celle-ci apparaîtront plus clairement à la lecture de la description qui suit à laquelle une planche de dessins est annexée.

La figure 1 représente le schéma électrique d'un oscillateur BF à diapason,

La figure 2 représente le schéma électrique d'une branche additionnelle permettant la stabilisation en température du fonctionnement de l'oscillateur de la figure 1, et

La figure 3 représente schématiquement un émetteur à sécurité intrinsèque pour la transmission de deux signaux basse fréquence incluant deux oscillateurs BF à diapason.

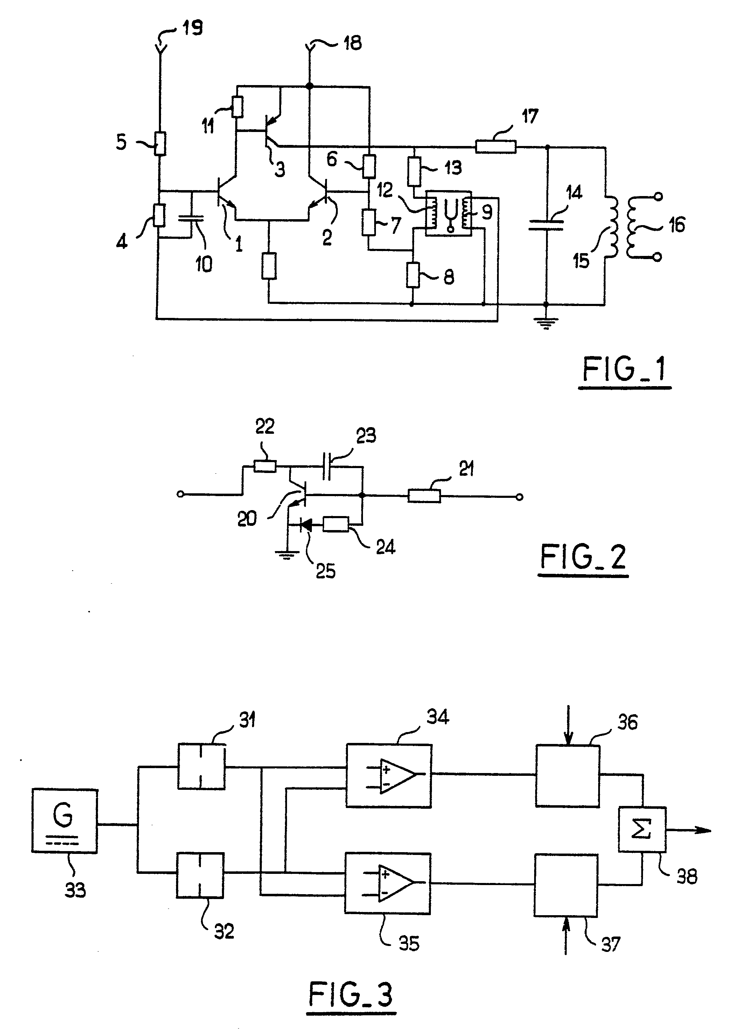

En référence maintenant à la figure 1, l'oscillateur BF à diapason comporte essentiellement un amplificateur différentiel à composants discrets constitués par deux transistors 1 et 2 montés en émetteur commun, dont les bases sont polarisées par deux ponts diviseurs de tension constitués par les résistances 4, 5, 6, 7 et 8.

L'enroulement de sortie 9 du diapason est relié à la première entrée de l'amplificateur différentiel, c'est-à-dire à la base du transistor 1, par l'intermédiaire de la résistance 4 en parallèle avec un condensateur de découplage 10.

La tension de sortie de l'amplificateur différentiel est prélevée aux bornes de la résistance 11 disposée sur le collecteur du transistor 1. Cette tension de sortie est appliquée à la base du transistor 3 dont le collecteur est relié, d'une part, à l'enroulement de commande 12 du diapason par l'intermédiaire d'une résistance 13 et, d'autre part, à un circuit-bouchon, par l'intermédiaire d'une résistance 17. Le circuit-bouchon est constitué par un jeu de condensateurs 14 et l'enroulement primaire 15 d'un transformateur, le signal de sortie de l'oscillateur étant prélevé aux bornes de l'enroulement secondaire 16 de ce transformateur. De façon préférée, ce circuit-bouchon présente un coefficient de température négatif du facteur de surtension.

La résistance 8 permet d'appliquer une faible contre-réaction sur la base du transistor 2 à travers la résistance 7 en phase avec le courant dans l'enroulement de commande 12 du diapason pour compenser le déphasage entrée-sortie du diapason qui s'accentue vers les fréquences les plus élevées.

La tension continue est appliquée aux bornes 19 et 18 de l'oscillateur.

Pour assurer un niveau constant du signal de sortie prélevé aux bornes de l'enroulement secondaire 16, l'oscillateur doit être alimenté en tension continue régulée. Dans ce but, et de manière à obtenir la sécurité de fonctionnement de cet oscillateur, deux circuits régulateurs de tension non représentés sur la figure sont utilisés. Connectés en parallèle entre les bornes de la source de tension continue, ils ont leurs sorties respectivement connectées aux bornes 19 et 18. De ce fait, toute modification intempestive des caractéristiques de l'un ou de l'autre des régulateurs, ainsi que de celles de l'oscillateur proprement dit se traduit par un affaiblissement notable du signal de sortie aux bornes de l'enroulement secondaire 16, le signal résiduel pouvant être par exemple de 30 dB inférieur au niveau nominal du signal de sortie dans des conditions normales.

En appelant facteur de durée le rapport de la durée à la base d'une impulsion faisant partie d'une suite d'impulsions identiques régulièrement espacées à la période de répétition, on peut dire que l'oscillateur fonctionne normalement avec un facteur de durée égal à 0,5 ; une modification de ce facteur due par exemple à la modification de l'une quelconque des caractéristiques de l'ensemble constitué par les deux régulateurs et l'oscillateur, entraîne un affaiblissement du signal de sortie grâce au circuit-bouchon de sortie formant filtre.

De manière à stabiliser en température l'oscillateur dans une gamme comprise entre − 30 et + 70 °C, il est préférable de disposer en contre-réaction entre la base du transistor 1 et le collecteur du transistor 3 une branche telle que représentée figure 2.

Cette branche est constituée par un transistor 20 dont la base est reliée au collecteur du transistor 3, par l'intermédiaire d'une résistance 21, et le collecteur à la base du transistor 1 par l'intermédiaire d'une résistance 22 et à sa propre base par l'intermédiaire d'un condensateur 23. L'émetteur du transistor 20 est relié, d'une part, à la masse et, d'autre part, à sa base par l'intermédiaire d'une résistance 24 en série avec une diode 25.

Cette branche mesure la composante continue de sortie du transistor 3 et corrige la polarisation du transistor 1 pour conserver le facteur de durée voisin de 0,5 dans toute la gamme possible de température. Toutefois, cette correction est limitée et pallie uniquement à de faibles variations des tensions de polarisation de façon à ne pas affecter la sécurité de l'ensemble.

Un oscillateur tel que décrit, alimenté en tension continue par l'intermédiaire de deux régulateurs de tension conformément à l'invention répond donc aux critères de sécurité de fonctionnement requis pour certaines applications, en particulier pour les applications ferroviaires.

En effet, dans les transmissions ferroviaires, aucune défaillance du matériel ne doit avoir de conséquence imprévue tendant à diminuer la sécurité.

De ce fait, pour les transmissions en matière ferroviaire, on utilise un émetteur de deux signaux basse fréquence incluant donc deux oscillateurs tels que celui qui a été précédemment décrit. Comme représenté figure 3 schématiquement, deux circuits régulateurs de tension 31 et 32 sont connectés en parallèle entre les bornes de la source de tension continue 33 ; ils ont leurs bornes de sortie respectivement reliées, d'une part, aux première et seconde entrées de l'amplificateur différentiel du premier oscillateur 34 et, d'autre part, aux seconde et première entrées de l'amplificateur différentiel du second oscillateur 35 selon un mode croisé. L'enroulement secondaire du transformateur de sortie de chaque oscillateur 34, 35 étant relié à un circuit de commande et d'adaptation d'impédance 36, 37 dont la sortie est reliée à un circuit mélangeur 38 par exemple constitué par les enroulements secondaires reliés en série de deux transformateurs dans la ligne de transmission.

De façon préférée, les circuits de commande et d'adaptation d'impédance 36, 37 incluent chacun deux transistors disposés en montage Darlington, dont la tension d'alimentation sert de tension de commande.

Lorsqu'une tension de commande est appliquée à l'un des circuits 36, 37, l'impédance ramenée à l'enroulement primaire correspondant du transformateur du circuit mélangeur 38 est nulle, tandis qu'en l'absence d'une tension de commande, cette impédance est égale à la valeur de la résistance disposée en série en sortie des transistors montés en Darlington.

Bien que seul un mode de réalisation de l'invention ait été décrit, il est évident que toute modification apportée par l'Homme de l'Art dans l'esprit de l'invention ne sortirait pas du cadre de la présente invention.

## Revendications

1. Oscillateur basse fréquence à diapason à sécurité intrinsèque alimenté en tension continue, comportant essentiellement en chaîne un amplificateur différentiel (1, 2) fonctionnant à saturation en mode opérationnel, à la première entrée duquel est connecté l'enroulement de sortie (9) dudit diapason, un transistor (3) monté en amplificateur à émetteur commun à la sortie dudit amplificateur différentiel, la sortie dudit transistor (3) étant connectée à l'enroulement de commande (12) dudit diapason, de manière à former une réaction par couplage magnétique avec ladite première entrée dudit amplificateur différentiel, et un circuit-bouchon (14, 15) dont l'inductance, reliée au collecteur dudit transistor (3) par l'intermédiaire d'une résistance (17), est constituée par l'enroulement primaire (15) d'un transformateur sur l'enroulement secondaire (16) duquel est recueilli le signal de sortie dudit oscillateur, caractérisé en ce qu'un premier et un second circuits régulateurs de tension sont connectés en parallèle entre les bornes de la source de tension continue d'alimentation, ledit premier circuit ayant ses bornes de sortie reliées à la première entrée de l'amplificateur différentiel par l'intermédiaire d'un premier pont diviseur de tension (4, 5), ledit second circuit ayant ses bornes de sortie reliées à la seconde entrée de l'amplificateur différentiel par l'intermédiaire d'un second pont diviseur de tension (6, 7, 8) et aux bornes d'entrée d'alimentation (18, masse) dudit amplificateur différentiel de telle manière que de la modification intempestive de l'une quelconque des caractéristiques desdits circuits résulte un affaiblissement notable du niveau du signal de sortie dudit oscillateur.

2. Oscillateur BF selon la revendication 1, caractérisé en ce qu'il comporte en outre, disposée en contre-réaction entre ladite première entrée dudit amplificateur différentiel et ladite sortie dudit transistor (3) une branche comprenant au moins un transistor (20) ayant sa base reliée d'une part à son collecteur par l'intermédiaire d'un condensateur (23) et d'autre part, au collecteur dudit transistor (3), monté en amplificateur, par l'intermédiaire d'une résistance (21), son collecteur à ladite première entrée dudit amplificateur différentiel par l'intermédiaire d'une résistance (22) et son émetteur relié, d'une part, à la masse et, d'autre part, à sa base par l'intermédiaire d'une résistance (24) en série avec une diode (25).

3. Emetteur à sécurité intrinsèque pour la transmission de deux signaux basse fréquence, alimenté par une source de tension continue, incluant deux oscillateurs basse fréquence à diapason à sécurité intrinsèque selon la revendication 1 et caractérisé en ce que les deux circuits régulateurs de tension (31, 32) ont leurs bornes de sortie connectées auxdits oscillateurs (34, 35) en mode croisé, d'une part, aux première et seconde entrées de l'amplificateur différentiel dudit premier oscillateur (34) par l'intermédiaire des ponts diviseurs de tension correspondants, et d'autre part, aux seconde et première entrées de l'amplificateur différentiel dudit second oscillateur (35) par l'intermédiaire des points diviseurs correspondants, l'enroulement secondaire du transformateur de sortie de chaque oscillateur étant relié à un circuit de commande et d'adaptation d'impédance (36, 37) dont la sortie est reliée à un circuit mélangeur (38) connecté à la ligne de transmission.

**Claims**

1. Reliable low frequency tuning fork oscillator supplied with D.C. voltage, somprising substantially in cascade a differential amplifier (1, 2) operating in its saturation region when actuated, to the first input of which the output winding (9) of the said tuning fork is connected, a transistor (3) arranged as an amplifier with common emitter at the output of the said differential amplifier, the output of the said transistor (3) being connected to the control winding (12) of the said tuning fork, so as to form a back coupling by means of magnetic coupling with the said first input of the said differential amplifier, and a tank circuit (14, 15) whose inductance, connected to the collector of the said transistor (3) by means of a resistor (17), forms the primary winding (15) of a transformer, the output signal of the said oscillator being output across the secondary winding (16) of the transformer, characterised in that a first voltage regulating circuit and a second voltage regulating circuit are connected in parallel between the terminals of the D.C. voltage supply source, the said first circuit having its output terminals connected to the first input of the differential amplifier via a first voltage divider bridge (4, 5), the said second circuit having its output terminals connected to the second input of the differential amplifier via a second voltage divider bridge (6, 7, 8) and to the supply input terminals (18, earth) of the said differential amplifier in such a manner that the inopportune modification of any one of the characteristics of the said circuits results in a marked weakening of the level of the output signal of the said oscillator.

2. Low frequency oscillator according to claim 1, characterised in that it also comprises, arranged for negative feedback between the said first input of the said differential amplifier and the said output of the said transistor (3) a branch comprising at least one transistor (20) having its base connected on the one hand to its collector via a capacitor (23) and on the other hand to the collector of the said transistor (3) arranged as an amplifier, via a resistor (21), its collector to the said first input of the said differential amplifier via a resistor (22) and its emitter connected on the one hand to earth and on the other hand to its base via a resistor (24) in series with a diode (25).

3. Reliable transmitter for transmission of two low frequency signals, which is supplied by a D.C. voltage source, including two reliable low frequency tuning fork oscillators according to claim 1 and characterised in that the two voltage regulating circuits (31, 32) have their output terminals connected to the said oscillators (34, 35) in crossed manner on the one hand to the first and second inputs of the differential amplifier of the said first oscillator (34) by way of the corresponding voltage divider bridges, and on the other hand to the second and first inputs of the differential amplifier of the said second oscillator (35) via the corresponding voltage divider bridges, the secondary winding of the output transformer of each oscillator being connected to an impedance adaptation and control circuit (36, 37) whose output is connected to a mixer circuit (38) connected to the transmission line.

**Ansprüche**

1. Eigensicherer Stimmgabel-Niederfrequenzoszillator, der gleichspannungsgespeist ist und im wesentlichen in Reihenschaltung einen im Operationsbetrieb in Sättigung arbeitenden Differenzverstärker (1, 2), an dessen ersten Eingang die Ausgangswicklung (9) des Stimmgabelkreises angeschlossen ist, einen in Emitterschaltung betriebenen Transistor (3) am Ausgang des Differenzverstärkers, wobei der Ausgang dieses Transistors (3) mit der Steuerwicklung (12) des Stimmgabelkreises verbunden ist, so daß eine über magnetische Kopplung bewirkte Rückkopplung auf den ersten Eingang des Differenzverstärkers gebildet ist, und einen Sperrkreis (14, 15) enthält, dessen mit dem Kollektor des Transistors (3) über einen Widerstand (17) verbundene Induktivität durch die Primärwicklung (15) eines Transformators gebildet ist, an dessen Sekundärwicklung (16) das Ausgangssignal des Oszillators abgenommen wird, dadurch gekennzeichnet, daß ein erster und ein zweiter Spannungsregelkreis parallel zwischen die Anschlüsse der Versorgungsgleichspannungsquelle geschaltet sind, wobei die Ausgangsanschlüsse des ersten Kreises mit dem ersten Eingang des Differenzverstärkers über eine erste Spannungsteilerbrücke (4, 5) verbunden sind und wobei die Ausgangsanschlüsse des zweiten Kreises mit dem zweiten Eingang des Differenzverstärkers über eine zweite Spannungsteilerbrücke (6, 7, 8) und mit den Versorgungseingangsanschlüssen (18, Masse) des Differenzverstärkers derart verbunden sind, daß eine ungewollte Änderung einer beliebigen Charakteristik dieser Kreise zu einer beträchtlichen Absenkung des Pegels des Ausgangssignals dieses Oszillators führt.

2. Niederfrequenzoszillator nach Anspruch 1, dadurch gekennzeichnet, daß er ferner in Gegenkopplung zwischen dem ersten Eingang des Differenzverstärkers und dem Ausgang des Transistors (3) einen Zweig aufweist, welcher wenigstens einen Transistor (20) enthält, dessen Basis einerseits über einen Kondensator (23) mit seinem Kollektor und andererseits über einen Widerstand (21) mit dem Kollektor des genannten, als Verstärker geschalteten Transistors (3) verbunden ist, während sein Kollektor mit dem ersten Eingang des Differenzverstärkers über einen Widerstand (22) und sein Emitter einerseits mit Masse und andererseits mit seiner Basis über einen Widerstand (24) in Reihe mit einer Diode (25) verbunden ist.

3. Eigensicherer Sender für die Übertragung von zwei Niederfrequenzsignalen, der gleichspannungsgespeist ist und zwei eigensichere Stimmgabel-Niederfrequenzoszillatoren nach Anspruch 1 enthält, dadurch gekennzeichnet, daß die zwei Spannungsregelkreise (31, 32) über ihre Ausgangsanschlüsse mit den Oszillatoren (34, 35) kreuzweise verbunden sind, und zwar einerseits über entsprechende Spannungsteilerbrücken mit dem ersten und dem zweiten Eingang des Differenzverstärkers des ersten Oszillators (34) sowie andererseits über entsprechende Spannungsteilerbrücken mit dem zweiten und mit dem ersten Eingang des Differenzverstärkers des zweiten Oszillators (35), wobei die Sekundärwicklung des Ausgangstransformators jedes Oszillators an eine Steuer- und Impedanzanpassungsschaltung (36, 37) angeschlossen ist, deren Ausgang mit einer Mischerschaltung (38) verbunden ist, welche an die Übertragungsleitung angeschlossen ist.

0 025 391

FIG_1

FIG_2

FIG_3